# EUROPÄISCHE PATENTSCHRIFT

(11) **EP 2 484 478 B1**
(45) Veröffentlichungstag und Bekanntmachung des Hinweises auf die Patenterteilung: **07.10.2015**
(21) Anmeldenummer: 11401675.1
(22) Anmeldetag: 20.12.2011
(51) Int. Cl.: B23K 26/38, B23K 26/40

(54) **Verfahren zum Einbringen einer Durchbrechung in ein Substrat**
Method for creating an opening through a substrate
Procédé de réalisation d'un passage dans un substrat

(30) Priorität: 07.02.2011 DE 102011000529
(43) Veröffentlichungstag der Anmeldung: 08.08.2012
(73) Patentinhaber: LPKF Laser & Electronics AG, 30827 Garbsen (DE)
(72) Erfinder: Roick, Florian, 27283 Verden (DE); Kohlmeier, Christian, 31714 Lauenhagen (DE); Bönigk, Stefan, 30657 Hannover (DE)
(74) Vertreter: Scheffler, Jörg

(56) Entgegenhaltungen:
- JP-A- H02 169 194
- JP-A- H07 132 385
- JP-A- 2005 021 897

## Beschreibung

Die Erfindung betrifft ein insbesondere zur Herstellung einer Schablone aus einem Blech bestimmtes Verfahren zum Einbringen einer Durchbrechung in ein Substrat mittels einer elektromagnetischen Strahlung, beispielsweise eines Lasers, bei dem eine Schnittlinie zum Ausschneiden einer allseitig eingeschlossenen, mehreckigen Fläche entlang vorbestimmter, die Durchbrechung einschließender, durch Eckpunkte verbundener Seitenlinien aus dem Substrat eingebracht wird, siehe, z.B., JP 2005/021897 A.

Ein solches Verfahren wird beispielsweise bei der Herstellung von Lotpastenschablonen für die Elektronikindustrie eingesetzt, die zum Lotpastenauftrag im industriellen Fertigungsprozess von Leiterplatten dienen. Die so hergestellten Schablonen bestehen beispielsweise aus Polyimid oder Stahl. Mit den nach dem Verfahren hergestellten Schablonen können die Lotpasten schnell und sicher aufgebracht werden.

Lotpastenschablonen werden für das Aufbringen von Lotdepots auf der Leiterplatte verwendet. Anschließend werden die SMD-Bauteile (SMD = surface mount device) in die Lotdepots gesetzt und in einem nachfolgenden Reflow-Lötprozess verlötet. Lotpastenschablonen können entsprechend der Kundenanforderung als blanke Bleche, Schablonen mit Randlochung oder eingeklebt im Rahmen gefertigt werden. Hierzu werden individuelle Durchbrechungen in das Blech eingebracht.

Zum Einbringen allseitig eingeschlossener Durchbrechungen in ein Substrat wird beim Stand der Technik der Fokuspunkt nicht etwa auf der Seitenlinie, sondern innerhalb der zu entfernenden Fläche der Durchbrechung gesetzt. Ausgehend von diesem Fokuspunkt wird zunächst der Laserfokus positioniert und anschließend der auch als Einstichfahne bezeichnete Einstich zu einem Eckpunkt zweier Seitenlinien als Startpunkt der Schnittlinie fortgesetzt. Anschließend wird die linienförmige Schnittlinie entlang jeder der die Ausnehmung begrenzenden Seitenlinien eingebracht.

Aus der JP H07 132385 A und der JP H02 169194 A ist jeweils ein Verfahren zum Einbringen einer Durchbrechung in ein Substrat mittels einer elektromagnetischen Strahlung bekannt, bei dem eine Schnittlinie zum Ausschneiden einer Fläche entlang vorbestimmter, die Durchbrechung einschließender Seitenlinien in das Substrat eingebracht wird. Hierzu wird die Schnittlinie beginnend in einem von den Seitenlinien beabstandeten inneren Bereich der Fläche mit einem Einstich bis zu einem Startpunkt auf einer Seitenlinie und weiter entlang aller weiteren Seitenlinien fortgesetzt, wobei der Einstich von dem inneren Bereich zu dem Startpunkt fortgesetzt wird, der die Seitenlinie in einen langen Seitenlinienabschnitt und einen kurzen Seitenlinienabschnitt unterteilt.

Bevor der Startpunkt nach einem vollständigen Umlauf entlang der Seitenlinien erneut erreicht wird, kommt es in der Praxis jedoch zu einer unerwünschten Verformung. Bedingt durch die wirkende Schwerkraft und die durch die Gasströmung der Prozessgase verursachte Krafteinwirkung, wobei die Gasströmung zum schnellen Abführen der Schmelze und der Vermeidung erneuter Anhaftungen dient, wird die auszuschneidende und bereits überwiegend abgetrennte Fläche nach unten gebogen.

Hierdurch wird einerseits der Abtransport der Schmelze beeinträchtigt, weil die Schmelze dadurch erneut an der Schnittkante anhaften kann, andererseits wird die Schnittkante dadurch unpräzise, dass der Laserstrahl nicht mehr orthogonal auf die Fläche, sondern aufgrund der Biegung auf einen konvex verformten Bereich der Fläche unter einem abweichenden Winkel auf die Seitenlinie trifft und die voreingestellten Parameter des Lasers nicht mehr optimal sind.

Man könnte daran denken, die Durchbrechungen derart in zwei aufeinanderfolgenden Arbeitsschritten einzubringen, dass zunächst eine innere Teilfläche mit einem großen Masseanteil entfernt wird und anschließend der verbliebene Rand entlang der Seitenlinien konturgenau entfernt wird. Hierdurch wird die Verfahrensdauer jedoch in unerwünschter Weise verlängert, sodass sich dieser Lösungsvorschlag als nicht praxisgerecht erwiesen hat.

Der Erfindung liegt die Aufgabe zugrunde, eine Möglichkeit zu schaffen, nachteilige Einflüsse aufgrund verformungsbedingter Änderungen der Orientierung der teilweise ausgeschnittenen Fläche zu minimieren.

Diese Aufgabe wird erfindungsgemäß mit einem Verfahren gemäß den Merkmalen des Anspruchs 1 gelöst. Die weitere Ausgestaltung der Erfindung ist den Unteransprüchen zu entnehmen.

Erfindungsgemäß ist also ein Verfahren vorgesehen, bei dem der Einstich von dem inneren Bereich zu einem Startpunkt fortgesetzt wird, der von einer Unstetigkeitsstelle, insbesondere einem zwei Seitenlinien verbindenden Eckpunkt wesentlich beabstandet ist, sodass der Startpunkt die Seitenlinie in einen langen Seitenlinienabschnitt und einen kurzen Seitenlinienabschnitt unterteilt, deren Länge zwischen 5 % und 15 % der Gesamtlänge der Summe aus dem kurzen Seitenlinienabschnitt und dem langen Seitenlinienabschnitt entspricht. Der Erfindung liegt die Erkenntnis zugrunde, ausgehend von dem in die Fläche eingebrachten Fokuspunkt den Einstich nicht zu einem Eckpunkt, sondern mit einem vorbestimmten Abstand hierzu bis zu der Seitenlinie zu führen, sodass der Startpunkt die Seitenlinie in einen kurzen Seitenlinienabschnitt und einen langen Seitenlinienabschnitt unterteilt. Anschließend wird die Schnittlinie entlang aller Seitenlinien eingebracht. Bevor nach einem vollen Umlauf der Startpunkt erneut erreicht wird, tritt jedoch ein gegenüber dem Stand der Technik überraschender, vorteilhafter Effekt ein. Durch die zunächst in dem kurzen Seitenlinienabschnitt noch fehlende Schnittlinie wird eine Aussteifung im Sinne eines Auflagers bewirkt. Im Gegensatz zum Stand der Technik, bei dem die Fläche kurz vor dem erneuten Erreichen des Startpunkts frei auskragt, also nur ein Auflager entlang einer Seitenlinie hat, hat die Fläche zunächst noch ein zusätzliches Auflager, welches durch den kurzen Seitenlinienabschnitt gebildet ist. Zwar tritt auch in diesem Fall unter dem Einfluss äußerer Kräfte eine Verformung der weitgehend ausgeschnittenen Fläche gegenüber dem Substrat ein, jedoch verläuft diese Biegelinie nicht parallel zu der Seitenlinie, sondern in einem Winkel, insbesondere orthogonal hierzu, sodass die nachteiligen Effekte nicht eintreten.

Dabei erweist es sich als besonders vorteilhaft, wenn die Schnittlinie ausgehend von dem Startpunkt beginnend mit dem langen Seitenlinienabschnitt und den sich anschließenden Seitenlinien eingebracht wird, sodass der das Auflager bildende Seitenlinienabschnitt auf den kurzen Seitenlinienabschnitt beschränkt ist. Überraschend hat sich gezeigt, dass zur Erzielung der erfindungsgemäßen Vorteile bereits eine sehr geringe Länge des kurzen Seitenlinienabschnitts vollkommen ausreichend ist. Zudem wird aufgrund der zunächst vorteilhaften Verformung entlang einer von der Seitenlinie abweichenden Biegelinie sichergestellt, dass auch beim Einbringen der Schnittlinie entlang des kurzen Seitenlinienabschnitts die Biegelinie von der Seitenlinie abweicht.

Dabei hat es sich in der Praxis bereits als sinnvoll erwiesen, wenn der kurze Seitenlinienabschnitt mit einer Länge zwischen 0,05 mm und 0,25 mm eingebracht wird, um so in der Praxis optimale Ergebnisse zu erzielen.

Dabei könnte der Einstich einen an sich beliebigen Verlauf aufweisen und sich beispielsweise auch der Seitenlinie asymptotisch annähern oder orthogonal zu der Seitenlinie verlaufend eingebracht werden. Besonders vorteilhaft ist es hingegen, wenn der Einstich mit dem langen Seitenlinienabschnitt einen spitzen Winkel einschließt, sodass der Startpunkt eindeutig definiert und eine überschneidende Bearbeitung durch mehrfache Schnittlinien in diesem Bereich ausgeschlossen ist.

Der Einstich kann grundsätzlich eine beliebige Länge aufweisen. Besonders vorteilhaft ist es hingegen, wenn der Einstich mit einer Länge zwischen 20 % und 30 % der Seitenlänge der mit dem kurzen Seitenlinienabschnitt oder mit dem langen Seitenlinienabschnitt verbundenen Seitenlinie eingebracht wird.

Hierdurch wird eine kontrollierte, vorbestimmbare Verformung der Fläche aufgrund der fortschreitenden Schnittlinie erreicht. Hierbei ergeben sich bevorzugte Einstichlängen zwischen 0,05 mm und 0,25 mm.

Der Einstich kann zu einem Startpunkt auf einer beliebigen Seitenlinie geführt werden. Besonders praxisnah ist es hingegen, wenn der Einstich mit einem Startpunkt auf der längsten Seitenlinie verbunden wird.

Das erfindungsgemäße Verfahren ist nicht auf bestimmte Größen der auszuschneidenden Fläche oder des Substrats beschränkt. Besonders sinnvoll ist hingegen eine Anwendung bei solchen Flächen, bei denen die Seitenlinien eine Länge zwischen 50 µm und 10 mm aufweisen.

In der Praxis sind viele Einsatzgebiete des erfindungsgemäßen Verfahrens realisierbar. Eine bevorzugte Anwendung des Verfahrens betrifft das Laserschneiden von Schablonen zum Lotpastenauftrag.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer Prinzipdarstellung in
- Fig. 1: ein Verfahren nach dem Stand der Technik;
- Fig. 2: ein erfindungsgemäßes Verfahren zum Einbringen einer Durchbrechung in ein Substrat.

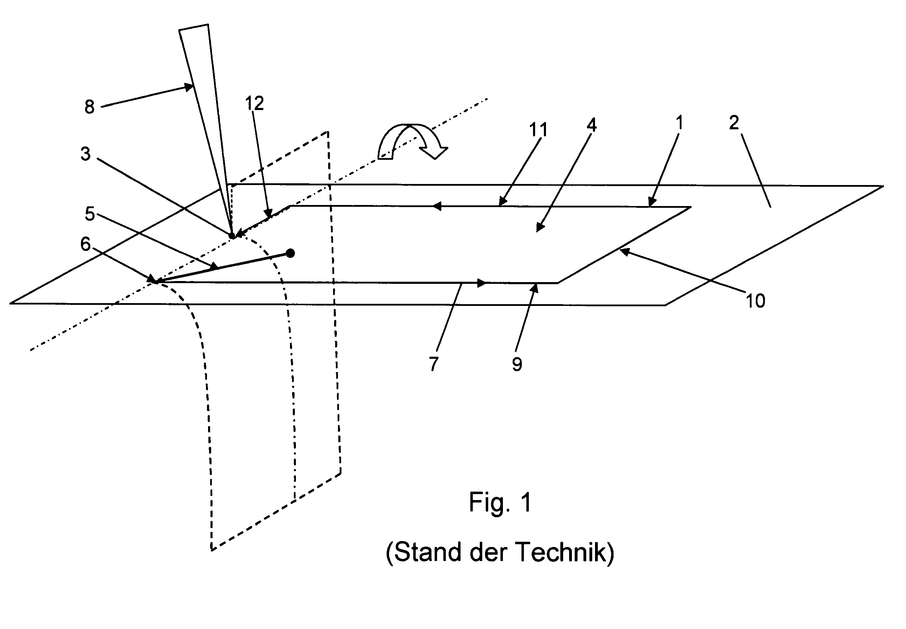

Figur 1 zeigt ein Verfahren zum Einbringen einer Durchbrechung 1 in ein Substrat 2, wie es aus dem Stand der Technik bekannt ist. Ausgehend von einem Fokuspunkt 3 einer fokussierten elektromagnetischen Strahlung 8 innerhalb der auszuschneidenden Fläche 4 wird ein Einstich 5 als Schnittlinie 7 zu einem Eckpunkt 6 als Schnittpunkt von zwei Seitenlinien 9, 12 fortgesetzt. Im Gegenuhrzeigersinn werden dann alle Seitenlinien 9, 10, 11, 12 abgefahren, sodass es in einem mittleren Bereich der letzten Seitenlinie 12 zu einer Verformung der in diesem Stadium bereits überwiegend abgetrennten Fläche 4 kommt. Wie zu erkennen schwenkt die Fläche 4 um eine Achse, die eine im Wesentlichen zu der zuletzt abzuarbeitenden Seitenlinie 12 parallele Orientierung aufweist. In der Folge trifft der fokussierte Strahl im Verformungsbereich auf eine konvexe Oberfläche der Fläche 4, sodass es zu Maßabweichungen in der Schnittkante kommt.

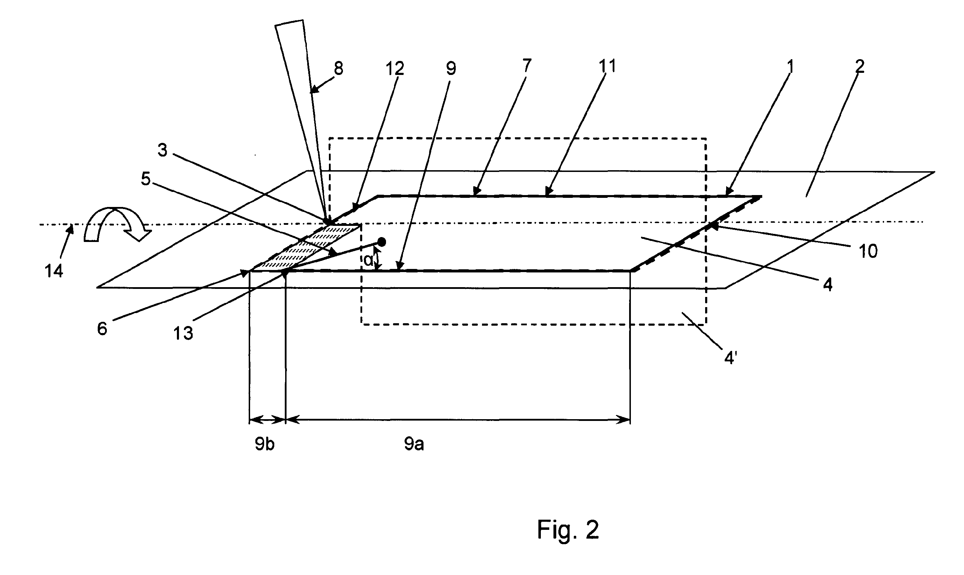

Demgegenüber ist in Figur 2 ein erfindungsgemäßes Verfahren zum Einbringen der Durchbrechung 1 in das Substrat 2 dargestellt, bei dem derartige, vorstehend beschriebene Maßabweichungen weitgehend vermieden werden. Wie zuvor beschrieben beginnt die mittels einer fokussierten elektromagnetischen Strahlung 8 einzubringende Schnittlinie 7 zunächst innerhalb eines von den Seitenlinien 9, 10, 11, 12 eingeschlossenen Bereichs der zu entfernenden Fläche 4 und setzt sich als Einstich 5 zu einem Startpunkt 13 auf der ersten Seitenlinie 9 fort, der von einem zwei Seitenlinien 9, 12 verbindenden Eckpunkt 6 beabstandet ist. Dabei unterteilt der Startpunkt 13 die Seitenlinie 9 in einen langen Seitenlinienabschnitt 9a und in einen kurzen Seitenlinienabschnitt 9b, wobei der Einstich 5 mit dem langen Seitenlinienabschnitt 9a einen Winkel α einschließt. Anschließend wird die Schnittlinie 7 entlang der ersten Seitenlinie 9 in den langen Seitenlinienabschnitt 9a und nachfolgend entlang der zweiten Seitenlinie 10 und der dritten Seitenlinie 11 bis etwa zur Mitte der vierten Seitenlinie 12 eingebracht. Bevor der Startpunkt 13 erneut erreicht wird, tritt jedoch ein gegenüber dem in Figur 1 gezeigten Stand der Technik ein überraschender, vorteilhafter Effekt ein. Durch die feste Verbindung zu dem kurzen Seitenlinienabschnitt 9b wird eine Aussteifung im Sinne eines Auflagers bewirkt. Die aufgrund nicht dargestellter Fluidströmung der Prozessgase sowie der Schwerkraft verformte, gestrichelt umrandete Fläche 4' hat dabei gegenüber dem verbliebenen Rest des Substrats 2 eine zu der vierten Seitenlinie 12 orthogonale Biegelinie 14 in derselben Ebene. Wie zu erkennen bleibt somit die vierte Seitenlinie 12 unbeeinträchtigt von der Verformung, sodass eine wesentlich verbesserte Qualität der Schnittlinie 7 ohne eine Verzögerung bei der Bearbeitung erreicht werden kann.

## Patentansprüche

1. Verfahren zum Einbringen einer Durchbrechung (1) in ein Substrat (2), insbesondere in ein Blech, mittels einer elektromagnetischen Strahlung (8), bei dem eine Schnittlinie (7) zum Ausschneiden einer mehreckigen Fläche (4) entlang vorbestimmter, die Durchbrechung (1) einschließender, durch Eckpunkte (6) verbundener Seitenlinien (9, 10, 11, 12) in das Substrat (2) eingebracht wird, **dadurch gekennzeichnet, dass** die Schnittlinie (7) beginnend in einem von den Seitenlinien (9, 10, 11, 12) beabstandeten inneren Bereich der Fläche (4) mit einem Einstich (5) bis zu einem Startpunkt (13) auf einer Seitenlinie (9) und weiter entlang aller weiteren Seitenlinien (9, 10, 11, 12) fortgesetzt wird der Einstich (5) von dem inneren Bereich zu dem Startpunkt (13) fortgesetzt wird, der von einer Unstetigkeitsstelle, insbesondere einem zwei Seitenlinien verbindenden Eckpunkt (6), beabstandet ist, sodass der Startpunkt (13) die Seitenlinie (9) in einen langen Seitenlinienabschnitt (9a) und einen kurzen Seitenlinienabschnitt (9b) unterteilt, deren Länge zwischen 5 % und 15 % der Gesamtlänge der Summe aus dem kurzen Seitenlinienabschnitt (9b) und dem langen Seitenlinienabschnitt (9a) entspricht.

2. Verfahren nach Anspruch 1, **dadurch gekennzeichnet, dass** die Schnittlinie (7) ausgehend von dem Startpunkt (13) beginnend mit dem langen Seitenlinienabschnitt (9a) und den sich anschließenden Seitenlinien (10, 11, 12) in den kurzen Seitenlinienabschnitt (9b) eingebracht wird.

3. Verfahren nach zumindest einem der vorhergehenden Ansprüche, **dadurch gekennzeichnet, dass** der kurze Seitenlinienabschnitt (9b) mit einer Länge zwischen 0,05 mm und 0,25 mm eingebracht wird.

4. Verfahren nach zumindest einem der vorhergehenden Ansprüche, **dadurch gekennzeichnet, dass** der Einstich (5) mit dem langen Seitenlinienabschnitt (9a) einen Winkel (α) einschließt.

5. Verfahren nach zumindest einem der vorhergehenden Ansprüche, **dadurch gekennzeichnet, dass** der Einstich (5) mit einer Länge zwischen 20 % bis 30 % der Seitenlänge der mit dem kurzen Seitenlinienabschnitt (9b) und/oder mit dem langen Seitenlinienabschnitts (9a) verbundenen Seitenlinie (10, 12) eingebracht wird.

6. Verfahren nach zumindest einem der vorhergehenden Ansprüche, **dadurch gekennzeichnet, dass** der Einstich (5) mit einer Länge zwischen 0,05 mm und 0,25 mm eingebracht wird.

7. Verfahren nach zumindest einem der vorhergehenden Ansprüche, **dadurch gekennzeichnet, dass** der Einstich (5) mit einem Startpunkt (13) auf einer langen Seitenlinie (9) verbunden wird.

8. Verfahren nach zumindest einem der vorhergehenden Ansprüche, **dadurch gekennzeichnet, dass** die Seitenlinien (9, 10, 11, 12) eine Länge zwischen 50 µm und 10 mm aufweisen.

9. Verfahren nach zumindest einem der vorhergehenden Ansprüche, **dadurch gekennzeichnet, dass** das Verfahren zum Laserschneiden von Schablonen zum Lotpastenauftrag eingesetzt wird.

## Claims

1. Method for introducing an opening (1) into a substrate (2), in particular into a metal sheet, by means of an electromagnetic radiation (8), in which a cutting line (7) for cutting out a polygonal area (4) along predetermined side lines (9, 10, 11, 12) enclosing the opening (1) and connected by corner points (6) is introduced into the substrate (2), **characterized in that**, beginning in an inner region of the area (4) that is at a distance from the side lines (9, 10, 11, 12), the cutting line (7) is continued with an incision (5) up to a starting point (13) on one side line (9) and further along all the other side lines (9, 10, 11, 12), and **in that** the incision (5) is continued from the inner region to the starting point (13), which is at a distance from a point of discontinuity, in particular a corner point (6) connecting two side lines, so that the starting point (13) divides the side line (9) into a long side-line portion (9a) and a short side-line portion (9b), the length of which corresponds to between 5% and 15% of the total length of the sum of the short side-line portion (9b) and the long side-line portion (9a).

2. Method according to Claim 1, **characterized in that**, from the starting point (13), the cutting line (7) is introduced by beginning with the long side-line portion (9a) and proceeding along the adjoining side lines (10, 11, 12) into the short side-line portion (9b).

3. Method according to at least one of the preceding claims, **characterized in that** the short side-line portion (9b) is introduced with a length of between 0.05 mm and 0.25 mm.

4. Method according to at least one of the preceding claims, **characterized in that** the incision (5) forms an angle (α) with the long side-line portion (9a).

5. Method according to at least one of the preceding claims, **characterized in that** the incision (5) is introduced with a length of between 20% and 30% of the side length of the side line (10, 12) that is connected to the short side-line portion (9b) and/or to the long side-line portion (9a).

6. Method according to at least one of the preceding claims, **characterized in that** the incision (5) is introduced with a length of between 0.05 mm and 0.25 mm.

7. Method according to at least one of the preceding claims, **characterized in that** the incision (5) is connected to a starting point (13) on a long side line (9).

8. Method according to at least one of the preceding claims, **characterized in that** the side lines (9, 10, 11, 12) have a length of between 50 µm and 10 mm.

9. Method according to at least one of the preceding claims, **characterized in that** the method is used for the laser cutting of templates for applying soldering paste.

## Revendications

1. Procédé pour réaliser un passage (1) dans un substrat (2), en particulier dans une tôle, au moyen d'un rayonnement électromagnétique (8), dans lequel une ligne de coupe (7) pour découper une surface polygonale (4) le long de lignes latérales prédéterminées (9, 10, 11, 12), incluant le passage (1), connectées par des points de coin (6), est réalisée dans le substrat (2), **caractérisé en ce que** la ligne de coupe (7), en commençant avec un entaillage (5) dans une région intérieure de la surface (4) espacée des lignes latérales (9, 10, 11, 12) jusqu'à un point de départ (13) sur une ligne latérale (9), continue ensuite le long de toutes les autres lignes latérales (9, 10, 11, 12), et **en ce que** l'entaillage (5) est poursuivi depuis la région intérieure jusqu'au point de départ (13), qui est espacé d'une zone de discontinuité, en particulier un coin (6) reliant deux lignes latérales, de sorte que le point de départ (13) divise la ligne latérale (9) en une portion de ligne latérale longue (9a) et une portion de ligne latérale courte (9b), dont la longueur correspond à 5 % à 15 % de la longueur totale de la somme de la portion de ligne latérale courte (9b) et de la portion de ligne latérale longue (9a).

2. Procédé selon la revendication 1, **caractérisé en ce que** la ligne de coupe (7) est réalisée en commençant à partir du point de départ (13) avec la portion de ligne latérale longue (9a) et avec les lignes latérales suivantes (10, 11, 12) jusque dans la portion de ligne latérale courte (9b).

3. Procédé selon au moins l'une quelconque des revendications précédentes, **caractérisé en ce que** la portion de ligne latérale courte (9b) est réalisée avec une longueur comprise entre 0,05 mm et 0,25 mm.

4. Procédé selon au moins l'une quelconque des revendications précédentes, **caractérisé en ce que** l'entaillage (5) forme un angle (α) avec la portion de ligne latérale longue (9).

5. Procédé selon au moins l'une quelconque des revendications précédentes, **caractérisé en ce que** l'entaillage (5) est réalisé avec une longueur comprise entre 20 % et 30 % de la longueur latérale de la ligne latérale (10, 12) reliée à la portion de ligne latérale courte (9b) et/ou à la portion de ligne latérale longue (9a).

6. Procédé selon au moins l'une quelconque des revendications précédentes, **caractérisé en ce que** l'entaillage (5) est réalisé avec une longueur comprise entre 0,05 mm et 0,25 mm.

7. Procédé selon au moins l'une quelconque des revendications précédentes, **caractérisé en ce que** l'entaillage (5) est relié à un point de départ (13) sur une ligne latérale longue (9).

8. Procédé selon au moins l'une quelconque des revendications précédentes, **caractérisé en ce que** les lignes latérales (9, 10, 11, 12) présentent une longueur comprise entre 50 µm et 10 mm.

9. Procédé selon au moins l'une quelconque des revendications précédentes, **caractérisé en ce que** le procédé est utilisé pour le découpage laser de gabarits pour l'application de pâte de brasage.
